# EUROPÄISCHE PATENTSCHRIFT

(11) **EP 2 127 503 B1**
(45) Veröffentlichungstag und Bekanntmachung des Hinweises auf die Patenterteilung: **11.05.2011**
(21) Anmeldenummer: 08715522.2
(22) Anmeldetag: 26.02.2008
(51) Int. Cl.: H05H 1/46

(54) **VORRICHTUNG UND EIN VERFAHREN ZUR PLASMAGESTÜTZTEN BESCHICHTUNG UND OBERFLÄCHENBEHANDLUNG GROSSVOLUMIGER BAUTEILE**
APPARATUS AND METHOD FOR PLASMA-ASSISTED COATING AND SURFACE TREATMENT OF VOLUMINOUS PARTS
DISPOSITIF ET PROCÉDÉ POUR L'APPLICATION DE REVÊTEMENT ET TRAITEMENT DE SURFACE ASSISTÉS PAR PLASMA DE PIÈCES VOLUMINEUSES

(30) Priorität: 26.02.2007 DE 102007009581
(43) Veröffentlichungstag der Anmeldung: 02.12.2009
(73) Patentinhaber: Dr. Laure Plasmatechnologie Gmbh, 70329 Stuttgart (DE)
(72) Erfinder: LAURE, Stefan, 70329 Stuttgart (DE)
(74) Vertreter: Geitz Truckenmüller Lucht
(86) Internationale Anmeldenummer: PCT/DE2008/000330
(87) Internationale Veröffentlichungsnummer: WO 2008/104160

(56) Entgegenhaltungen:
- EP-A- 1 593 756
- WO-A-2005/069703
- WO-A-2006/108395
- US-A- 5 211 995
- US-A1- 2004 101 635

## Beschreibung

### Stand der Technik

Die Erfindung geht aus von einer Vorrichtung und einem Verfahren zur plasmagestützten Beschichtung und Oberflächenbehandlung großvolumiger Bauteile.

Wird die Oberfläche eines Bauteils einem Plasma ausgesetzt, so können bei entsprechender Wahl der Plasmaparameter wie Druck, Temperatur und Plasmazusammensetzung die Funktionalität und die Eigenschaften der Oberfläche gezielt beeinflusst und verändert werden. Aus dem Stand der Technik sind Verfahren zur Behandlung, Modifizierung oder Beschichtung einer Oberfläche aus beliebigem Material bekannt, bei denen Teilchen- oder Energieströme aus einem Plasma genutzt werden. Hierzu zählen unter anderem Plasmaspritzen, Lichtbogenplasmaschmelzen, Plasmawärmebehandlungsverfahren, Plasma-CVD-Verfahren und Plasmareinigung. Die Veränderung der Funktionalität von Werkstückoberflächen erfolgt durch gezielten Angriff von Plasmateilchen. Dies kann durch die Wechselwirkung mit Teilchen mit bestimmten chemischen Eigenschaften oder durch die Einwirkung von Strahlung, die vom Plasma emittiert wird, geschehen. Bei Verfahren zur Plasmabeschichtung eines Bauteils wird der Beschichtungswerkstoff durch Zufuhr von Energie in den dampfförmigen oder gasförmigen Zustand versetzt und aus der Dampf- oder Gasphase auf dem Bauteil abgeschieden.

Zur Erzeugung eines Plasmas wird ein Plasmabrenner verwendet, beispielsweise ein Lichtbogen-Plasmagenerator, ein Hochfrequenz-Plasmagenerator oder ein Mikrowellenplasmagenerator.

Die oben beschriebenen thermischen Plasmen eignen sich für die Bearbeitung von Bauteilen, die sich durch eine gewisse Temperaturelastbarkeit auszeichnen. Bei Bauteilen aus Kunststoff oder bei bereits lackierten Bauteilen, die einer maximalen Temperatur von nur 100-200°C ausgesetzt sein dürfen, können derartige Verfahren nicht eingesetzt werden.

Eine Plasmabehandlung mit bekannten Plasmageneratoren ist zwar bei kleinen Bauteilen angemessen, jedoch eignet sie sich für große Bauteile nicht. Das Plasma tritt nur in einem eng begrenzten Bereich auf und bildet sich nicht über das gesamte Bauteil aus. Zur Plasmabehandlung der gesamten Oberfläche eines großen Bauteils muss daher der Plasmastrahl über das Bauteil geführt werden. Dies ist bei Bauteilen wie beispielsweise Karosserien von Fahrzeugen mit einem hohen Zeit- und Kostenaufwand verbunden.

Zur Erzeugung von dünnen Plasmen mit relativ geringen Energiedichten werden ebenfalls Hochfrequenzgeneratoren benutzt. Ihr Frequenzbereichbereich liegt zwischen einigen hundert Kilohertz und mehreren zehn Gigahertz. Das Plasma wird an den Oberflächen von Elektroden oder Antennen quellförmig erzeugt und breitet sich in den Raum aus. Der Beschichtungswerkstoff wird durch Sputtern aus einem so genannten Sputter-Target herausgelöst oder bei den Verfahren des Physical Vapor Deposition, kurz PVD, verdampft und scheidet sich anschließend an dem Bauteil ab. Als nachteilig erweist sich, dass sich die Zusammensetzung und die Temperatur des Plasmas mit wachsendem Abstand vom Plasmabrenner verändert. Dadurch wird das Abscheiden einer gleichmäßigen Schicht auf der gesamten Oberfläche des Bauteils erschwert. Außerdem können mit diesen Verfahren nur Beschichtungen aus einer begrenzten Anzahl an Beschichtungswerkstoffen hergestellt werden.

Ein Nachteil der Plasmabehandlung der gesamten Oberfläche eines großen Bauteils mit den PVD-Verfahren besteht darin, dass die mittlere freie Weglänge groß und der Druck in der Vakuumkammer sehr klein sein muss. Dies ist aufgrund der mit der Größe des Bauteils verbundenen Größe der Vakuumkammer mit einem hohen technischen und finanziellen Aufwand verbunden.

Darüber hinaus eignen sich die bekannten Verfahren nicht zur Behandlung von Spalten, Fügestellen, Hohlräumen und Hinterschneidungen, welche bei Karosserien von Fahrzeugen auftreten. Die der Plasmaquelle abgewandten Flächen sind keinem gleichmäßigen Plasma ausgesetzt. Auf den der Plasmaquelle zugewandten Flächen kann aufgrund der starken Gradienten eine gleichmäßige Bearbeitung nicht garantiert werden. Dies gilt vor allem für Bearbeitungsvorgänge, die von Strahlungsprozessen dominiert werden.

Ein Beispiel einen Vorrichtung und eines Verfahrens zur Plasmabehandlung grossvolumiger Bauteile ist in WO-A2-2005/069703 Vorgeschlagen.

Die Erfindung und ihre Vorteile

Demgegenüber haben die erfindungsgemäße Vorrichtung mit den Merkmalen des Anspruchs 1 und das erfindungsgemäße Verfahren mit den Merkmalen des Anspruchs 7 den Vorteil, dass große Bauteile über die gesamte Oberfläche einer gleichmäßig wirkenden Plasmabehandlung unterzogen werden können, und dass durch Reaktion der im Plasma enthaltenen Substanzen an der Oberfläche der Bauteile eine Schicht oder ein Schichtsystem abgeschieden werden kann. Durch mindestens zwei Schwingkreise mit mindestens zwei Hochfrequenzgeneratoren mit jeweils einstellbarer Induktivität und Kapazität und durch Anbindung oder Einbindung des Bauteils in mindestens zwei Schwingkreise wird an der Oberfläche und in gegebenenfalls auch in den durch das Bauteil begrenzten Hohlräumen ein Plasma erzeugt, dessen Teilchendichte und dessen Energie einstellbar und variabel sind. Die Ausbildung des Plasmas hängt von den Komponenten des Schwingkreises ab, insbesondere der Anregungsfrequenz, den Kapazitäten der Schwingkreise und des Bauteils und den Induktivitäten der Schwingkreise und den Bauteils. Dabei sind die Induktivität und die Kapazität des Bauteils vorgegeben. Alle anderen Komponenten und die zugehörigen Parameter sind einstellbar. Die Vorrichtung und das Verfahren zeichnen sich aufgrund der vielen einstellbaren Parameter durch eine hohe Flexibilität und Variabilität der an den Oberflächen eines Bauteils zu erzeugenden Energie- und Teilchendichte des Plasmas aus.

Durch mindestens einen weiteren zusätzlichen Schwingkreis wird ein zusätzlicher Freiheitsgrad gewonnen um die Parameter des Plasmas an der Oberfläche des Bauteils einzustellen. Die Anregungsfrequenzen des ersten und des zweiten sowie gegebenenfalls weiterer Hochfreqenzgeneratoren können identisch oder verschieden sein. Werden alle Hochfrequenzgeneratoren mit derselben Anregungsfrequenz betrieben, so führt dies dazu, dass im Vergleich zu nur einem Hochfrequenzgenerator mehr Leistung im Plasma umgesetzt wird. Werden die Anregungsfrequenzen variiert und für jeden Schwingkreis unterschiedlich eingestellt, so können unterschiedliche Anregungsmodi im Plasma aktiviert werden. Auf diese Weise können bestimmte Teilchen, wie Atome, Elektronen oder Ionen im Plasma erzeugt werden, chemische Reaktionen im Plasma ermöglicht oder unterstützt werden und die Emission von Strahlung einer gewünschten Wellenlänge hervorgerufen werden.

Die Schwingkreise sind unanhängig voneinander und können unabhängig voneinander betrieben werden. Hierzu ist jeder Schwingkreis mit einem eigenen Hochfrequenzgenerator und zusätzlichen Induktivitäten und Kapazitäten ausgestattet.

Die Vorrichtung kann als Multifrequenzplasmaerzeuger betrieben werden.

Die Behandlung und Beschichtung schließt sowohl die Außen- als auch die Innenflächen ein. Spalte, Fügestellen, Hohlräume und Hinterscheidungen werden ebenfalls bearbeitet. Derartige Bereiche treten insbesondere bei Bauteilen auf, welche aus mehreren Elementen zusammengesetzt sind.

Die erfindungsgemäße Vorrichtung und das erfindungsgemäße Verfahren können bei beliebigen Bauteilen unterschiedlicher Größe eingesetzt werden. Sie eignen sich insbesondere für große Bauteile wie beispielsweise Fahrzeugkarosserien, Flugzeug- und Maschinenteile, um nur einige Beispiele zu nennen. Voraussetzung hierzu ist, dass die Vakuumskammer die notwendige Größe aufweist, und dass das Bauteil in die Vakuumkammer eingeführt und gegen die Vakuumkammer isoliert werden kann. Zum Einführen des Bauteils in die Vakuumkammer und zum Ausführen des Bauteils aus der Vakuumkammer kann die Vakuumkammer mit einer Transporteinrichtung ausgestattet sein.

Das Bauteil wird in eine Vakuumkammer der Vorrichtung eingebracht. Hierzu dient vorzugsweise ein Transporteinrichtung. Anschließend wird das Bauteil an den ersten Schwingkreis mit erstem Hochfrequenzgenerator angeschlossen oder an den ersten Schwingkreis zumindest teilweise berührungsfrei gekoppelt. Hierzu wird das Bauteil galvanisch, kapazitiv oder induktiv in den Schwingkreis eingebunden. Es besteht auch die Möglichkeit, Mischformen der Ankopplung zu verwenden. Das Bauteil kann beispielsweise an einem Pol galvanisch und an dem anderen Pol kapazitiv an den Schwingkreis angekoppelt werden. Eine induktive Ankopplung erfolgt beispielsweise über eine Spule, die nahe dem Bauteil in der Vakuumkammer angeordnet wird. Das Bauteil bildet damit einen Teil des ersten Schwingkreises. Anschließend oder gleichzeitig wird das Bauteil auf dieselbe Weise in den zweiten Schwingkreis eingebunden. Der hochfrequente Wechselstrom des ersten und des zweiten Schwingkreises fließt durch das Bauteil. Die Induktivität und die Kapazität des Bauteils beeinflussen dabei die Induktivität und die Kapazität des Schwingkreises. Um die optimale Ankopplung der elektrischen Leistung an das Bauteil sicherzustellen, müssen die beiden Schwingkreise, die jeweils aus dem zu bearbeitenden Bauteil und den zusätzlichen Kapazitäten und Induktivitäten bestehen, entsprechend angepasst werden. Dies geschieht durch die Variation der Kapazitäten und Induktivitäten der Schwingkreise. Die Einstellung der Kapazitäten und Induktivitäten der Schwingkreise kann entweder manuell oder automatisch erfolgen. Bei einer automatischen Einstellung werden zunächst die Kapazität und die Induktivität des Bauteils ermittelt. Die Variation der Kapazitäten und Induktivitäten der Schwingkreises bewirkt eine Veränderung der Frequenz der Schwingkreise.

Mit der erfindungsgemäßen Vorrichtung und dem erfindungsgemäßen Verfahren sind unterschiedliche Bearbeitungen des Bauteils möglich. Es können eine oder mehrere Schichten auf dem Bauteil abgeschieden werden und die Oberfläche des Bauteils kann aktiviert werden um sie auf eine nachfolgende Bearbeitung, beispielsweise eine Lackierung oder Beschichtung vorzubereiten. Ferner können Beschichtungen der Oberfläche durch die mittels des Plasmas erzeugten Strahlung, beispielsweise im UV-Bereich, gehärtet werden. Außerdem können UV-Lacke vernetzt werden. Die Oberflächen können geätzt oder von Keimen befreit werden. Durch die Ausbildung von Oberflächenentladungen treten elektrische Effekte an der Oberfläche auf, die zu deren Bearbeitung eingesetzt werden können.

Das Plasma wird durch die Ausbildung von Wirbelströmen an der Oberfläche des Bauteils erzeugt. Der durch das Bauteil fließende Wechselstrom bewirkt oszillierende Magnetfelder, die sich abhängig von der Geometrie des Bauteils in dessen Umgebung ausbreiten. Die zeitliche Änderung des Magnetfelds führt zu elektrischen Feldern, die für die Erzeugung und Aufrechterhaltung des Plasmas in der Umgebung des Bauteils verantwortlich sind.

Nach einer vorteilhaften Ausgestaltung der Erfindung sind in der Vakuumkammer Antennen, Reflektoren, Bleche, Rohre und/ oder Gitter aus Metall vorgesehen. Das Bauteil selbst stellt eine Antenne dar, von der elektromagnetische Wellen in den Raum der Vakuumskammer abgestrahlt werden. Dieser Effekt kann unterstützt werden durch weitere antennenartige Elemente in der Umgebung des Bauteils. Hierzu zählen Bleche oder Gitter aus Metall. Spiralförmig angeordnete Rohre beispielsweise aus Kupfer können diesen Effekt ebenfalls bewirken. In diese Teile koppeln die elektromagnetischen Wellen ein und sorgen für eine zusätzliche Plasmaerzeugung in einem gewissen Abstand vom Bauteil. Auf diese Weise kann der Strahlungsfluss des Plasmas in Richtung auf das Bauteil gesteuert werden.

Nach einer weiteren vorteilhaften Ausgestaltung der Erfindung sind an oder in der Vakuumkammer ein oder mehrere Mikrowellenplasmageneratoren angeordnet. Sie dienen dazu, an bestimmten Stellen eine konstante Teilchenoder Energiedichte des Plasmas zu unterstützen, das Plasma zu zünden, insbesondere bei hohen Drücken oder hohen Teilchendichten in der Vakuumkammer, und zur Vorkonditionierung oder Aufbereitung der Arbeitsmedien oder ihrer Komponenten vor oder bei dem Eintritt in die Vakuumkammer. Sie können beispielsweise zur Aufbereitung der Precursorstoffe eingesetzt werden. Vorteilhafterweise ist die Position der Mikrowellenplasmageneratoren einstellbar um sie optimal an das Bauteil anpassen zu können. Zusätzlich dazu besteht die Möglichkeit, die Mikrowellenplasmageneratoren außerhalb der Vakuumkammer anzuordnen und über einen Anschluss an die Vakuumkammer zu koppeln.

Mit der erfindungsgemäßen Verfahren und der erfindungsgemäßen Vorrichtung können Einkomponenten-Stoffe im Plasma umgesetzt werden. Hierzu wird unter Umständen eine zusätzliche Energiequelle, beispielsweise ein zusätzlicher Plasmabrenner oder einer der oben angegebenen Mikrowellenplasmageneratoren benötigt. Die Umwandlung der Stoffe findet direkt an der Oberfläche des Bauteils in dem dort brennenden Plasma statt.

Durch die zeitliche Variation der Teilchen- oder Energiedichten können Gradientenschichten an der Oberfläche des Bauteils abgeschieden werden. Durch die zeitliche Variation der dem Plasma zugeführten Stoffe können mehrere verschiedene Schichten oder eine Schichtenfolge an der Oberfläche des Bauteils abgeschieden werden. Dies kann exakt gesteuert werden.

Nach einer weiteren vorteilhaften Ausgestaltung der Erfindung wird ein Arbeitsgas in die Vakuumkammer gegeben. Dadurch kann der Druck in der Vakuumkammer erhöht werden. Es sind beispielsweise Drücke bis 1.000 Pa möglich. Das Arbeitsgas tritt mit der Oberfläche des Bauteils chemisch in Wechselwirkung. Als Arbeitsgase können je nach Anforderung verschiedene Gase verwendet werden.

Nach einer weiteren vorteilhaften Ausgestaltung der Erfindung wird eine zusätzliche Flüssigkeit verdampft und über ein Ventil in die Vakuumkammer gegeben. Der Flüssigkeitsdampf erfüllt dieselbe Aufgabe wie die Arbeitsgase.

Nach einer weiteren vorteilhaften Ausgestaltung der Erfindung wird über den Hochfrequenzgenerator eine Wechselspannung mit 0,1 bis 10 MHz in den Schwingkreis eingespeist wird. Besonders bevorzugt liegt die Wechselspannung zwischen 1 und 4 MHz.

Nach einer weiteren vorteilhaften Ausgestaltung der Erfindung wird die Vakuumkammer auf einen Druck zwischen 0,05 und 1.000 Pa evakuiert. Im Unterschied zu den aus dem Stand der Technik bekannten Verfahren kann der Arbeitsdruck je nach Anwendung auf einige 10 mbar erhöht werden. Damit steht ein weiteres Werkzeug zur Steuerung der Zahl der Teilchen, die mit der Oberfläche des zu bearbeitenden Bauteils in Wechselwirkung treten, zur Verfügung.

Weitere Vorteile und vorteilhafte Ausgestaltungen der Erfindung sind der nachfolgenden Beschreibungen, der Zeichnung und den Ansprüchen zu entnehmen.

### Zeichnung

In der Zeichnung ist ein Ausführungsbeispiel einer erfindungsgemäßen Vorrichtung zur Plasmabeschichtung dargestellt. Im folgenden ist diese Vorrichtung erläutert. Es zeigen:
- Figur 1: Vorrichtung zur Plasmabehandlung in einer Ansicht von vorne,
- Figur 2: Vorrichtung zur Plasmabehandlung in einer Ansicht von oben,
- Figur 3: Schaltplan zur der Vorrichtung gemäß Figur 1 und 2,
- Figur 4: Schaltplan einer Vorrichtung zur Plasmabehandlung mit drei Schwingkreisen, in welche das Bauteil elektrisch leitend eingebunden ist,
- Figur 5: Schaltplan einer weiteren Vorrichtung zur Plasmabehandlung mit drei Schwingkreisen, wobei zwei Schwingkreise mit Antennen ausgestattet sind,
- Figur 6: Schaltplan einer Vorrichtung zur Plasmabehandlung gemäß Figur 4, welche zusätzlich mit Mikrowellenplasmageneratoren ausgestattet ist,
- Figur 7: elektrisch leitende Verbindung zwischen dem Bauteil und einem Schwingkreis,
- Figur 8: Einbindung eines Bauteils in einen Schwingkreis über eine elektrisch leitende Verbindung und eine Antenne,
- Figur 9: Einbindung gemäß Figur 8 mit einer zusätzlichen Parallelschaltung in der Phasenleitung,
- Figur 10: Einbindung einer Bauteils in zwei Schwingkreise mit zwei Hochfrequenzgeneratoren.

### Beschreibung des Ausführungsbeispiels

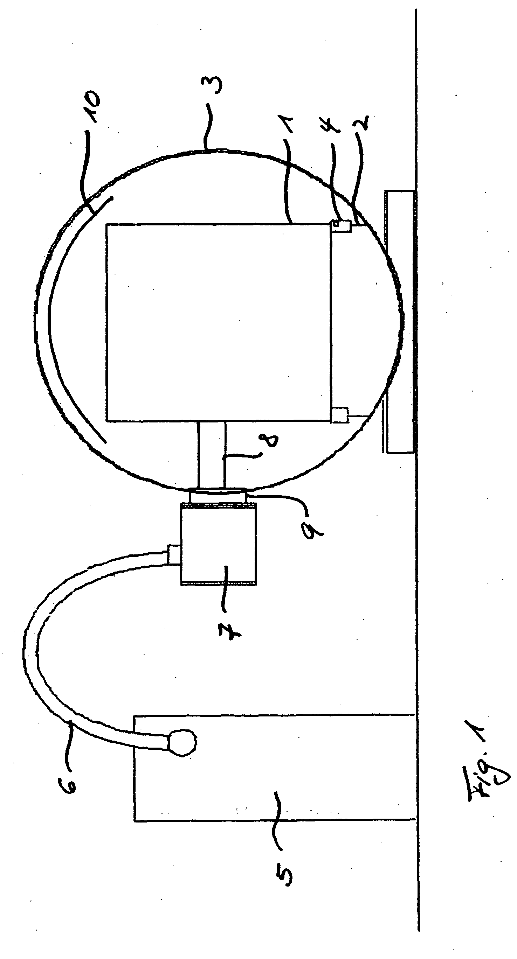

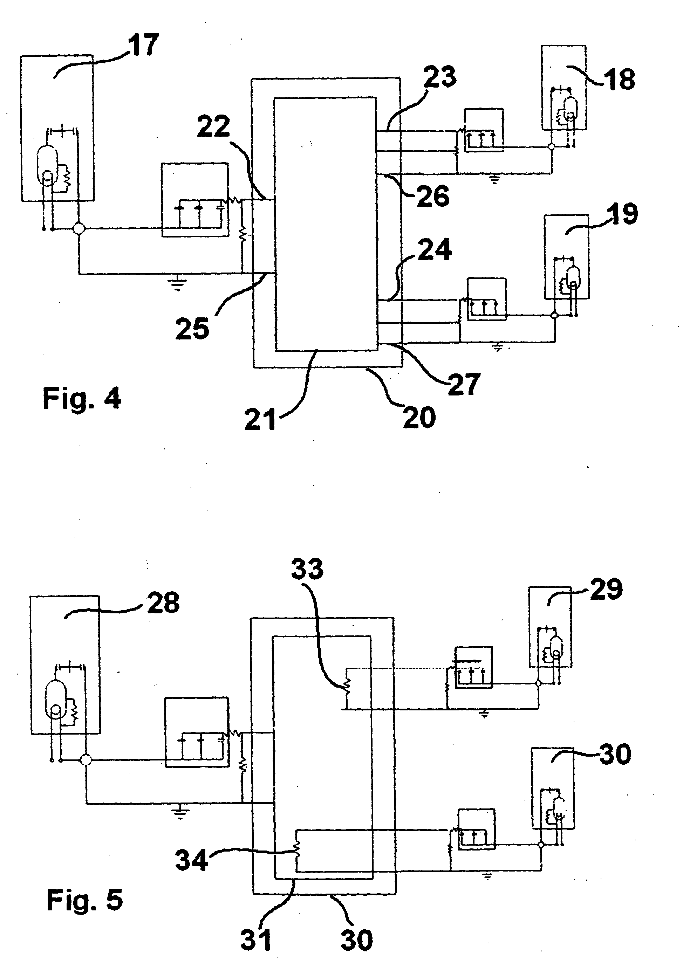

Die Figuren 1 bis 3 zeigen eine Vorrichtung zur plasmagestützten Beschichtung und Oberflächenbehandlung in einer Ansicht von vorne und von oben sowie einen zugehörigen Schaltplan. Diesen Figuren kann entnommen werden, wie ein Bauteil in einen ersten Schwingkreis eines ersten Hochfrequenzgenerators eingebunden wird. Die Figuren 4 bis 6 und 10 zeigen das Einbinden eines Bauteils in mehrere Schwingkreise.

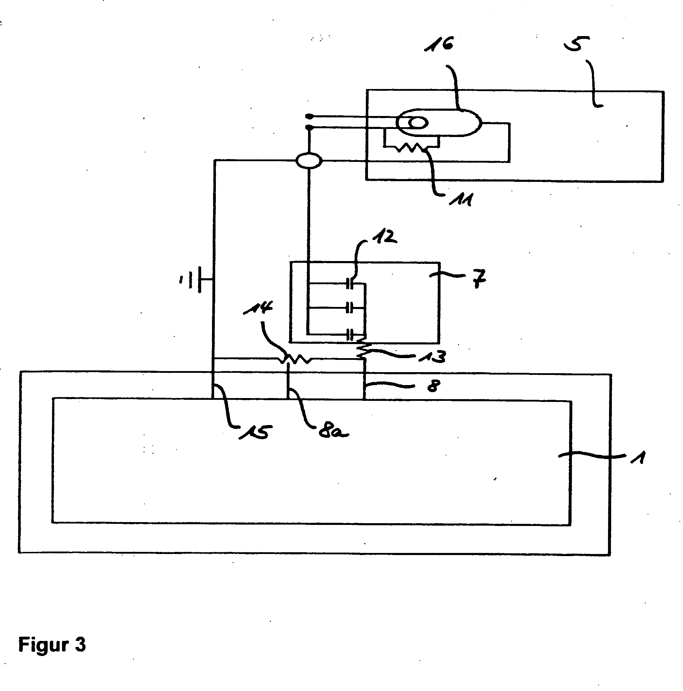

Bei der Vorrichtung gemäß Figuren 1 bis 3 wird ein zu bearbeitendes Bauteil 1 über Schienen 2 und in der Zeichnung nicht erkennbare Rollen in eine Vakuumkammer 3 eingefahren. Schienen und Rollen bilden zusammen eine Transporteinrichtung. Diese kann zusätzlich mit einem Antrieb ausgestattet sein, der in der Zeichnung nicht dargestellt ist. An den Schienen 2 ist eine Isolation 4 vorgesehen, welche das Bauteil 1 gegen die Vakuumkammer 3 isoliert. Mit Erreichen seiner Endposition wird der Kontakt zwischen einem ersten Hochfrequenz-Schwingkreis und dem Bauteil geschlossen. Dies erfolgt über einen in der Zeichnung nicht erkennbaren Gleitkontakt, der durch Formschluss an dem Bauteil 1 haftet. Das Bauteil ist nun Teil des ersten Schwingkreises. Der erste Schwingkreis besteht abgesehen vom Bauteil 1 aus einem ersten Hochfrequenzgenerator 5 mit einer in Figur 3 dargestellten Rückkoppelspule 11, einem Koaxial-Kabel 6, einem Außenschwingkreis 7 und einer Hochfrequenz-Zuleitung 8, an deren Enden der Gleitkontakt vorgesehen ist. In der Vakuumkammer 3 ist eine Hochfrequenz-Durchführung 9 für die Hochfrequenz-Zuleitung 8 vorgesehen. Oberhalb des Bauteils ist ein Reflektor 10 für das Plasma vorgesehen.

Weitere Schwingkreise und Hochfrequenzgeneratoren sind auf entsprechende oder ähnliche Weise an der Vakuumkammer angeordnet und mit dem Bauteil verbunden. Schaltpläne hierzu sind in den Figuren 4 bis 6 dargestellt.

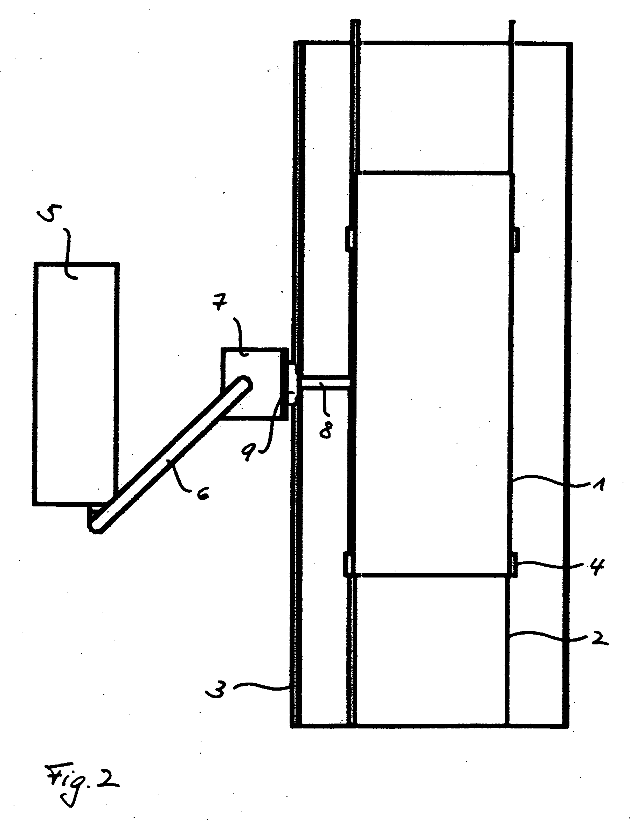

Figur 3 zeigt schematisch den Schaltplan der Vorrichtung gemäß Figuren 1 und 2. Der erste Hochfrequenzgenerator 5 versorgt den ersten Schwingkreis über ein Koaxial-Kabel 6 mit Wechselstrom. Der erste Hochfrequenzgenerator 5 verfügt über eine Rückkoppelspule 11, deren Induktivität automatisch einstellbar ist. Derjenige Teil des Schwingkreises, der sich außerhalb der Vakuumkammer befindet, wird als Außenschwingkreis 7 bezeichnet. Im Außenschwingkreis 7 sind drei Kondensatoren 12 vorgesehen. Sie können alle oder nur teilweise in den Schwingkreis integriert werden um die Gesamtkapazität zu verändern. Die Induktivität des Schwingkreises wird im wesentlichen durch das Bauteil 1 bestimmt. Das Bauteil 1 ist über die Hochfrequenz-Zuleitung 8 mit dem Außenschwingkreis 7 verbunden. Um die Induktivität des Schwingkreises auf das Bauteil abzustimmen, ist eine Spule 13 am Außenschwingkreis vorgesehen. Zusätzlich dazu ist eine weitere Spule 14 mit einem Abgriff an der Hochfrequenz-Zuleitung 8 unmittelbar an der Spule 13 vorgesehen. Diese wird nur bei Bedarf zur Anpassung der Gesamtinduktivität in den Schwingkreis integriert. Für diesen Fall wird anstelle der Hochfrequenz-Zuleitung 8 die Hochfrequenz-Zuleitung 8a verwendet. Das Bauteil 1 kann optional über die Leitung 15 geerdet werden.

Durch Einspeisen eines hochfrequenten Wechselstroms bei sehr niedriger Leistung wird der Kontakt zwischen Bauteil 1 und Schwingkreis überprüft. Erfüllt der Kontakt die Anforderungen, so wird die Vakuumkammer 3 evakuiert. Nachdem der Druck in der Vakuumkammer 3 einen bestimmten, von der Art der Behandlung abhängigen Wert erreicht hat, wird hochfrequenter Wechselstrom in den Schwingkreis eingespeist. An der Oberfläche des Bauteils 1 entsteht das Plasma, welches für die Behandlung des Bauteils benötigt wird. Die Steuerung des Plasmaeinflusses an der Oberfläche des Bauteils erfolgt durch die Regelung der Anodenspannung einer Senderöhre 16, die den Wechselstrom in den Schwingkreis einspeist. Durch Überwachung der Strom-Spannungskennlinie der Senderöhre 16 des Schwingkreises wird die Effizienz der Einkopplung der elektrischen Leistung in das Plasma kontrolliert. Die Feinabstimmung des Schwingkreises während der Plasmabehandlung erfolgt durch Variation der Induktivität der Rückkoppelspule des Schwingkreises. Im Vorfeld besteht zusätzlich die Möglichkeit, die Grobabstimmung des Systems durch Einfügen zusätzlicher Induktivitäten 14 oder Kapazitäten 12 in den Schwingkreis auf das zu bearbeitende Bauteil vorzunehmen.

Figur 4 zeigt den Schaltplan eines Ausführungsbeispiels einer Vorrichtung zur plasmagestützten Beschichtung und Oberflächenbehandlung mit drei Schwingkreisen und drei Hochfrequenzgeneratoren 17, 18 und 19. Jeder der drei Hochfrequenzgeneratoren ist zusammen mit dem in einer Vakuumkammer 20 angeordneten Bauteil 21 in jeweils einen Schwingkreis eingebunden. Je ein Hochfrequenzgenerator und das Bauteil bilden zusammen mit den zusätzlichen Kapazitäten und Induktivitäten einen ersten, einen zweiten und einen dritten Schwingkreis. Jeder der drei Schwingkreise ist mit Kondensatoren, Spulen und einer Senderöhre entsprechend dem Schaltplan in Figur 3 ausgestattet. Auf eine detaillierte Beschreibung wird daher an dieser Stelle verzichtet. Das Bauteil ist in alle drei Schwingkreise elektrisch leitend eingebunden. Hierzu ist eine Zuleitung 22, 23 und 24 eines jeden Schwingkreises an das Bauteil angeschlossen. Ein zweiter Anschluss 25, 26 und 27 ist geerdet.

Im Unterschied dazu ist bei einem weiteren Ausführungsbeispiel mit drei Hochfrequenzgeneratoren gemäß Figur 5 nur ein erster Hochfrequenzgenerator 28 entsprechend dem Schaltplan in Figur 3 mit einem Bauteil 31 in einer Vakuumkammer 32 verbunden. Die beiden weiteren Hochfrequenzgeneratoren 29 und 30 sind mit Antennen 33 und 34 ausgestattet, um die Energie des zweiten und dritten Schwingkreises auf das Bauteil 31 abzustrahlen und berührungsfrei zu übertragen. Die beiden Antennen 33 und 34 sind als Spulen ausgebildet. Die Kopplung des Bauteils 31 an den zweiten und dritten Schwingkreis erfolgt daher induktiv.

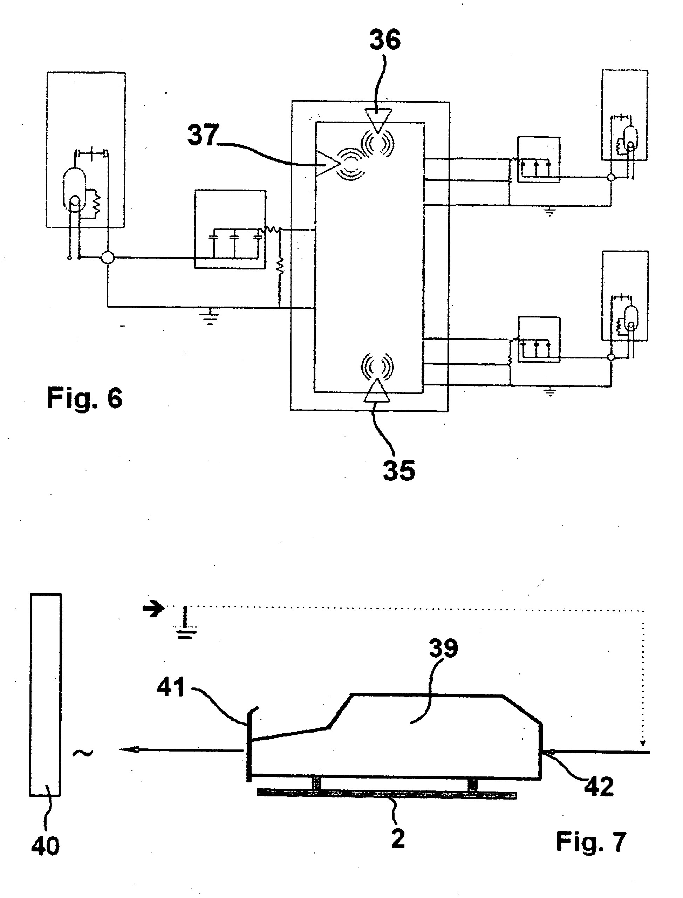

Das in Figur 6 dargestellte Ausführungsbeispiel stimmt bis auf drei zusätzliche Mikrowellenplasmageneratoren 35, 36 und 37 mit dem Ausführungsbeispiel gemäß Figur 4 überein. Die Mikrowellenplasmageneratoren sind innerhalb der Vakuumkammer 20 angeordnet.

Die Figuren 7 bis 10 zeigen verschiedene Möglichkeiten der Ankopplung des Bauteils an einen Schwingkreis mit Hochfrequenzgenerator gemäß Figur 3. Zur Vereinfachung sind in den Figuren 7 bis 10 lediglich der jeweilige Hochfrequenzgenerator, das Bauteil und die Ankopplung an das Bauteil dargestellt. Bei dem Bauteil 39 handelt es sich jeweils um eine Fahrzeugkarosserie.

In Figur 7 ist das Bauteil 39 an zwei Polen galvanisch und damit elektrisch leitend in den Schwingkreis eines ersten Hochfrequenzgenerators 40 eingebunden. Das auf Schienen 2 angeordnete Bauteil wird beim Einführen in eine in Figur 1 dargestellte Vakuumkammer mit einer als Anschluss dienenden Platte 41 galvanisch verbunden. Die Platte ermöglicht eine formschlüssige Verbindung mit dem Bauteil und garantiert damit eine ausreichende mechanische Berührung für die galvanische Verbindung. Der zweite Pol 42 ist mit Masse verbunden und liegt auf Erdpotential.

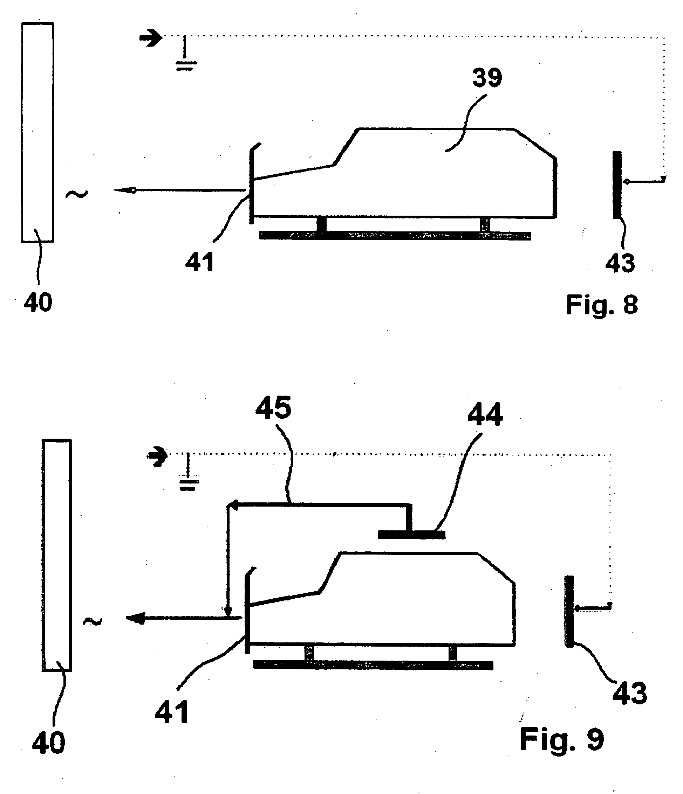

In Figur 8 ist das Bauteil 39 wie in Figur 7 an einem Pol über eine Platte 41 galvanisch und an dem anderen Pol kapazitiv über eine Kondensatorplatte 43 in den Schwingkreis des Hochfrequenzgenerators 40 eingekoppelt. Bei der Einkopplung gemäß Figur 9 ist zusätzlich dazu eine weitere Kondensatorplatte 44 über eine Phasenleitung 45 mit dem Schwingkreis verbunden und galvanisch an das Bauteil 39 gekoppelt.

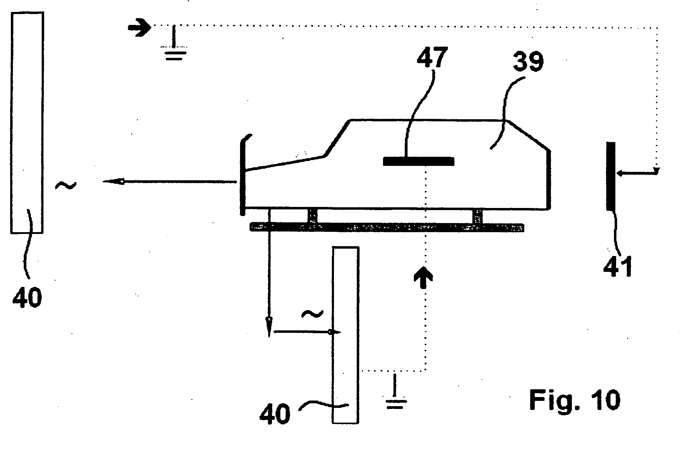

Figur 10 zeigt schematisch die Ankopplung des Bauteils 39 an den ersten Hochfrequenzgenerator 40 und an einen zweiten Hochfrequenzgenerator 40 über jeweils einen galvanischen Anschluss und einen kapazitiven Anschluss. Die Ankopplung an die beiden Schwingkreise der beiden Hochfrequenzgeneratoren 40 erfolgt in beiden Fällen nach dem in Figur 8 dargestellten Prinzip. Hierzu ist der Schwingkreis des zweiten Hochfrequenzgenerators 40 ebenfalls mit einer Kondensatorplatte 46 ausgestattet.

Sämtliche Merkmale der Erfindung können sowohl einzeln als auch in beliebiger Kombination miteinander.

### Bezugszeichen

- 1: Bauteil
- 2: Schiene
- 3: Vakuumkammer
- 4: Isolation
- 5: erster Hochfrequenzgenerator
- 6: Koaxial-Kabel
- 7: Außenschwingkreis
- 8: Hochfrequenz-Zuleitung
- 9: Hochfrequenz-Durchführung
- 10: Reflektor
- 11: Rückkoppelspule
- 12: Kondensator des Außenschwingkreises
- 13: Spule
- 14: Spule
- 15: Leitung
- 16: Senderöhre
- 17: ersten Hochfrequenzgenerator
- 18: zweiter Hochfrequenzgenerator
- 19: dritter Hochfrequenzgenerator
- 20: Vakuumkammer
- 21: Bauteil
- 22: Hochfrequenz-Zuleitung
- 23: Hochfrequenz-Zuleitung
- 24: Hochfrequenz-Zuleitung
- 25: zweiter Anschluss
- 26: zweiter Anschluss
- 27: zweiter Anschluss
- 28: ersten Hochfrequenzgenerator
- 29: zweiter Hochfrequenzgenerator
- 30: dritter Hochfrequenzgenerator
- 31: Bauteil
- 32: Vakuumkammer
- 33: Antenne
- 34: Antenne
- 35: Mikrowellenplasmagenerator
- 36: Mikrowellenplasmagenerator
- 37: Mikrowellenplasmagenerator
- 38, 39: Bauteil
- 40: erster Hochfrequenzgenerator
- 41: Platte
- 42: zweiter Pol
- 43: Kondensatorplatte
- 44: Kondensatorplatte
- 45: Phasenleitung
- 46: Kondensatorplatte

## Patentansprüche

1. Vorrichtung zur plasmagestützten Beschichtung und Oberflächenbehandlung großvolumiger Bauteile
mit einer Vakuumkammer (3, 20, 32) mit einer oder mehreren Pumpen, mit einem ersten Schwingkreis mit einem ersten Hochfrequenzgenerator (5, 17, 28, 40),
mit einer einstellbaren Kapazität und einer einstellbaren Induktivität des ersten Schwingkreises,
mit einem ersten Anschluss zur Einbindung des Bauteils (1, 21, 32, 39) in den ersten Schwingkreis, **dadurch gekennzeichnet dass** die Vorrichtung
mindestens einen zweiten Schwingkreis mit einem zweiten Hochfrequenzgenerator (18, 29, 40),
einen zweiten Anschluss zur Einbindung des Bauteils (1, 21, 32, 39) in den zweiten Schwingkreis,
eine einstellbaren Kapazität und eine einstellbaren Induktivität des zweiten Schwingkreises aufweist.

2. Vorrichtung nach Anspruch 1, **dadurch gekennzeichnet, dass** der zweite Anschluss zur Einbindung des Bauteils (1, 21, 32, 39) in den zweiten Schwingkreis galvanisch, kapazitiv oder induktiv ausgebildet ist.

3. Vorrichtung nach Anspruch 1oder 2, **dadurch gekennzeichnet, dass** der zweite Schwingkreis mit mindestens einer Antenne (33, 34) oder einer Platte (43, 44, 46) ausgestattet ist um die Energie des Schwingkreises berührungslos auf das Bauteil (1, 21, 32, 39) zu übertragen, dass die Antenne (33, 34) oder die Platte (43, 44, 46) in der Vakuumkammer angeordnet ist.

4. Vorrichtung nach einem der vorhergehenden Ansprüche, **dadurch gekennzeichnet, dass** der zweite Schwingkreis mit einem Anschluss ausgestattet ist, um ein Pol des Bauteils (1, 21, 32, 39) galvanisch mit dem zweiten Schwingkreis zu verbinden, und dass der Schwingkreis mit einer Kondensatorplatte (43, 44, 46) oder Elektrode ausgestattet ist, um einen zweiten Pol des Bauteils (1, 21, 32, 39) kapazitiv mit dem zweiten Schwingkreis zu verbinden.

5. Vorrichtung nach einem der vorhergehenden Ansprüche, dass sie zusätzlich mit mindestens einem Mikrowellenplasmagenerator (35, 36, 37) ausgestattet ist.

6. Vorrichtung nach Anspruch 5, **dadurch gekennzeichnet, dass** die Position des Mikrowellenplasmagenerators (35, 36, 37) relativ zum Bauteil (1, 21, 32, 39) einstellbar ist.

7. Verfahren zur plasmagestützten Beschichtung und Oberflächenbehandlung großvolumiger Bauteile
, **dadurch gekennzeichnet,**
**dass** das Bauteil (1, 21, 31, 39) in einer Vakuumkammer (3, 20, 32)
angeordnet und die Vakuumkammer (3, 20, 32) evakuiert wird,
**dass** das Bauteil (1, 21, 31, 39) an einen ersten Schwingkreis mit einem ersten Hochfrequenzgenerator (5, 17, 28, 40) angeschlossen wird,
**dass** die Induktivität und/ oder die Kapazität des ersten Schwingkreises auf das Bauteil (1, 21, 31, 39) abgestimmt wird,
**dass** mit mindestens einem zweiten Schwingkreis und mindestens einem zweiten Hochfrequenzgenerator (18, 19, 29, 30, 40) zusätzlich Energie erzeugt wird, die auf das Bauteil (1, 21, 32, 39) übertragen wird.

8. Verfahren nach Anspruch 7, **dadurch gekennzeichnet, dass** die Induktivität und/ oder die Kapazität des zweiten Schwingkreises auf das Bauteil (1, 21, 31, 39) abgestimmt wird.

9. Verfahren nach Anspruch 7 oder 8, **dadurch gekennzeichnet, dass** das Bauteil (1, 21, 32, 39) zumindest mit einem Pol des zweiten Schwingkreises galvanisch verbunden wird.

10. Verfahren nach Anspruch 7, 8 oder 9, **dadurch gekennzeichnet, dass** mindestens ein Pol des zweiten Schwingkreises kapazitiv oder induktiv mit dem Bauteil (1, 21, 32, 39) verbunden wird.

11. Verfahren nach einem der Ansprüche 7 bis 10, **dadurch gekennzeichnet, dass** ein Beschichtungswerkstoff in die Vakuumkammer (3, 20, 32) eingeleitet wird, und dass der Beschichtungswerkstoff aus der Plasmaphase auf dem Bauteil (1, 21, 32, 39) abschieden wird.

12. Verfahren nach einem der Ansprüche 7 bis 11, **dadurch gekennzeichnet, dass** das Plasma durch mindestens einen zusätzlichen Mikrowellenplasmagenerator (35, 36, 37) gezündet wird.

13. Verfahren nach einem der Ansprüche 7 bis 12, **dadurch gekennzeichnet, dass** die Teilchendichte und/ oder die Energiedichte an der Oberfläche des Bauteils (1, 21, 32, 39) durch mindestens einen zusätzlichen Mikrowellengenerator (35, 36, 37) räumlich und zeitlich konstant gehalten oder zeitlich variiert wird.

14. Verfahren nach einem der Ansprüche 7 bis 13, **dadurch gekennzeichnet, dass** Arbeitsgase und/ oder Beschichtungsstoffe durch mindestens einen Mikrowellenplasmagenerator (35, 36, 37) aufbereitet oder vorkonditioniert werden.

## Claims

1. Apparatus for plasma-assisted coating and surface treatment of voluminous parts
with a vacuum chamber (3, 20, 32) with one or more pumps,
with a first oscillating circuit with a first high-frequency generator (5, 17, 28, 40),
with an adjustable capacitance and an adjustable inductance of the first oscillating circuit,
with a first connection to incorporate the part (1, 21, 32, 39) in the first oscillating circuit, **characterised in that** the apparatus has at least a second oscillating circuit with a second high-frequency generator (18, 29, 40),
a second connection to incorporate the part (1, 21, 32, 39) in the second oscillating circuit,
an adjustable capacitance and an adjustable inductance of the second oscillating circuit.

2. Apparatus according to claim 1, **characterised in that** the second connection to incorporate the part (1, 21, 32, 39) in the second oscillating circuit is designed galvanically, capacitively or inductively.

3. Apparatus according to claim 1 or 2, **characterised in that** the second oscillating circuit is equipped with at least one antenna (33, 34) or one plate (43, 44, 46) for contactless transfer of the energy of the oscillating circuit to the part (1, 21, 32, 39), and that the antenna (33, 34) or the plate (43, 44, 46) is arranged in the vacuum chamber.

4. Apparatus according to one of the previous claims, **characterised in that**
the second oscillating circuit is equipped with a connection to galvanically connect a pole of the part (1, 21, 32, 39) to the second oscillating circuit, and that the oscillating circuit is equipped with a capacitor plate (43, 44, 46) or electrode to capacitively connect a second pole of the part (1, 21, 32, 39) to the second oscillating circuit.

5. Apparatus according to one of the previous claims, **characterised in that** it is additionally equipped with at least one microwave plasma generator (35, 36, 37).

6. Apparatus according to claim 5, **characterised in that** the position of the microwave plasma generator (35, 36, 37) can be adjusted relative to the part (1, 21, 32, 39).

7. Method for plasma-assisted coating and surface treatment of voluminous parts, **characterised in that**
the part (1, 21, 31, 39) is arranged in a vacuum chamber (3, 20, 32) and the vacuum chamber (3, 20, 32) is evacuated,
the part (1, 21, 31, 39) is connected to a first oscillating circuit with a first high-frequency generator (5, 17, 28, 40),
the inductance and/or capacitance of the first oscillating circuit is adapted to the part (1, 21, 31, 39),
with at least one second oscillating circuit and at least one second high-frequency generator (18, 19, 29, 30, 40) additional energy is produced that is transferred to the part (1, 21, 32, 39).

8. Method according to claim 7, **characterised in that** the inductance and/or capacitance of the second oscillating circuit is adapted to the part (1, 21, 31, 39).

9. Method according to claim 7 or 8, **characterised in that** the part (1, 21, 32, 39) is galvanically connected to at least one pole of the second oscillating circuit.

10. Method according to claim 7, 8 or 9, **characterised in that** at least one pole of the second oscillating circuit is capacitively or inductively connected to the part (1, 21, 32, 39).

11. Method according to claims 7 to 10, **characterised in that** a coating material is introduced into the vacuum chamber (3, 20, 32), and that the coating material from the plasma phase is deposited on the part (1, 21, 32, 39).

12. Method according to claims 7 to 11, **characterised in that** the plasma is ignited by at least one additional microwave plasma generator (35, 36, 37).

13. Method according to claims 7 to 12, **characterised in that** the particle density and/or the energy density on the surface of the part (1, 21, 32, 39) is kept constant in terms of space and time or is varied in terms of time by at least one additional microwave plasma generator (35, 36, 37).

14. Method according to claims 7 to 13, **characterised in that** the working gases and/or coating materials are processed or preconditioned by at least one microwave plasma generator (35, 36, 37).

## Revendications

1. Dispositif pour l'application de revêtement et traitement de surface assistés par plasma de pièces volumineuses avec une chambre à vide (3, 20, 32) dotée d'une ou de plusieurs pompes, avec un premier circuit oscillant doté d'un premier oscillateur haute fréquence (5, 17, 28, 40),
avec une capacité et une inductance réglables du premier circuit oscillant, avec un premier raccord pour l'intégration du composant (1, 21, 32, 39) dans le premier circuit oscillant, **caractérisé en ce que** le dispositif présente
au moins un second circuit oscillant doté d'un second oscillateur haute fréquence (18, 29, 40),
un second raccord pour l'intégration du composant (1, 21, 32, 39) dans le second circuit oscillant,
une capacité et une inductance réglables du second circuit oscillant.

2. Dispositif selon la revendication 1, **caractérisé en ce que** le second raccord pour l'intégration du composant (1, 21, 32, 39) dans le second circuit oscillant présente un fonctionnement galvanique, capacitif ou inductif.

3. Dispositif selon la revendication 1 ou 2, **caractérisé en ce que** le second circuit oscillant est équipé au moins d'une antenne (33, 34) ou d'une plaque (43, 44, 46) servant à transmettre sans contact l'énergie du circuit oscillant au composant (1, 21, 32, 39), l'antenne (33, 34) ou la plaque (43, 44, 46) étant disposée dans la chambre à vide.

4. Dispositif selon l'une quelconque des revendications précédentes, **caractérisé en ce que** le second circuit oscillant est équipé d'un raccord servant à relier galvaniquement un pôle du composant (1, 21, 32, 39) au second circuit oscillant, et **en ce que** le circuit oscillant est équipé d'une plaque de condensateur (43, 44, 46) ou d'une électrode servant à relier capacitivement un second pôle du composant (1, 21, 32, 39) au second circuit oscillant.

5. Dispositif selon l'une quelconque des revendications précédentes, **caractérisé en ce qu'**il est équipé en plus d'au moins un générateur de plasma micro-onde (35, 36, 37).

6. Dispositif selon la revendication 5, **caractérisé en ce que** la position du générateur de plasma micro-onde (35, 36, 37) est réglable par rapport au composant (1, 21, 32, 39).

7. Procédé pour l'application de revêtement et traitement de surface assistés par plasma de pièces volumineuses, **caractérisé en ce que** le composant (1, 21, 31, 39) est disposé dans une chambre à vide (3, 20, 32) et que le vide est fait dans la chambre à vide (3, 20, 32),
le composant (1, 21, 31, 39) est raccordé à un premier circuit oscillant avec un premier oscillateur haute fréquence (5, 17, 28, 40),
l'inductance et/ou la capacité du premier circuit oscillant sont adaptées en fonction du composant (1, 21, 31, 39),
de l'énergie est en plus générée avec au moins un second circuit oscillant et au moins un second oscillateur haute fréquence (18, 19, 29, 30, 40), cette énergie étant transmise au composant (1, 21, 32, 39).

8. Procédé selon la revendication 7, **caractérisé en ce que** l'inductance et/ou la capacité du second circuit oscillant sont adaptées en fonction du composant (1, 21, 31, 39).

9. Procédé selon la revendication 7 ou 8, **caractérisé en ce que** le composant (1, 21, 32, 39) est relié galvaniquement à au moins un pôle du second circuit oscillant.

10. Procédé selon la revendication 7, 8 ou 9, **caractérisé en ce qu'**au moins un pôle du second circuit oscillant est relié capacitivement ou inductivement au composant (1, 21, 32, 39).

11. Procédé selon l'une quelconque des revendications 7 à 10, **caractérisé en ce qu'**un matériau de revêtement est introduit dans la chambre à vide (3, 20, 32), et que le matériau de revêtement de la phase plasma est déposé sur le composant (1, 21, 32, 39).

12. Procédé selon l'une quelconque des revendications 7 à 11, **caractérisé en ce que** le plasma est amorcé par au moins un générateur de plasma micro-onde supplémentaire (35, 36, 37).

13. Procédé selon l'une quelconque des revendications 7 à 12, **caractérisé en ce que** la densité des particules et/ou la densité du flux d'énergie à la surface du composant (1, 21, 32, 39) est maintenue constante dans l'espace et dans le temps ou varie dans le temps au moyen d'au moins un générateur de plasma micro-onde supplémentaire (35, 36, 37).

14. Procédé selon l'une quelconque des revendications 7 à 13, **caractérisé en ce que** les gaz de travail et/ou les matériaux de revêtement sont traités ou préconditionnés par au moins un générateur de plasma micro-onde (35, 36, 37).
